# EUROPEAN PATENT APPLICATION

(11) **EP 4 746 589 A1**
(43) Date of publication of application: **20.05.2026**
(21) Application number: 24839825.7
(22) Date of filing: 12.07.2024
(51) Int. Cl.: H05K 1/03, H05K 3/38

(54) **LAMINATE, CIRCUIT BOARD, AND PRODUCTION METHOD FOR CIRCUIT BOARD**

(30) Priority: 12.07.2023 JP 2023114559
(71) Applicant: Denka Company Limited, Tokyo 103-8338 (JP)
(72) Inventor: KUDO Jotaro, Tokyo 103-8338 (JP); NISHIWAKI Kodai, Tokyo 103-8338 (JP); ICHIKAWA Isamu, Tokyo 103-8338 (JP)
(74) Representative: Hoffmann Eitle
(86) International application number: PCT/JP2024/025314
(87) International publication number: WO 2025/013937

(57) **Abstract**

A laminate including a first metal layer, an insulating layer disposed on the first metal layer, and a second metal layer disposed on the insulating layer, wherein: the insulating layer has a Tg of 25°C or more and 90°C or less; and a ratio (α2/α1) of a coefficient of linear expansion α2 in a rubbery region of the insulating layer with respect to a coefficient of linear expansion α1 in a glass region of the insulating layer is 4.3 or more and 8.0 or less.

## Description

### TECHNICAL FIELD

The present disclosure relates to: a laminate to be preferably used in the production of a circuit board (metal-based circuit board); a circuit board formed from the laminate; and a production method for the circuit board.

### BACKGROUND

Hitherto, various kinds of circuit boards have been utilized as circuit boards for forming hybrid integrated circuits having electronic/electric components such as semiconductor elements mounted thereon. Circuit boards are classified into resin circuit boards, ceramic circuit boards, and metal-based circuit boards, etc., on the basis of the circuit material.

Resin circuit boards are cheap but such boards have low thermal conductivity, and therefore, are limited to uses in which a relatively small amount of electricity is used. Since ceramics have characteristics of high electrical insulation properties and high heat resistance, ceramic circuit boards are suitable for uses in which a relatively large amount of electricity is used but have a drawback of being expensive. Meanwhile, metal-based circuit boards have intermediate properties between resin circuit boards and ceramic circuit boards, and are preferable for general purpose uses in which a relatively large amount of electricity is used, for example, uses such as in inverters for refrigerators, inverters for industrial air-conditioning, power supplies for industrial robots, and power supplies for vehicles, etc.

For example, Patent Document 1 discloses a method in which a circuit board composition having as essential components a specific epoxy resin, a curing agent, and an inorganic filler is used to obtain a circuit board which has excellent stress mitigation, heat resistance, humidity resistance, and heat dissipation properties.

### PRIOR ART DOCUMENTS

### PATENT LITERATURE

Patent Document 1: JP 2008-266533 A

### SUMMARY OF INVENTION

### TECHNICAL PROBLEM

In recent years, due to the spread of plug-in hybrid vehicles and electric vehicles, etc., there is an increasing demand for rapid chargers for vehicles. Circuit boards used in such chargers are used with higher voltages than conventional vehicle circuit boards and are required to have higher reliability.

An objective of one aspect of the present disclosure is to provide a laminate which is useful in the production of a circuit board having both excellent adhesive strength and excellent heat cycle properties. Further, an objective of one aspect of the present disclosure is to provide: a circuit board having both excellent adhesive strength and excellent heat cycle properties; and a production method therefor.

### SOLUTION TO PROBLEM

The present disclosure, for example, relates to [1] to [9] below.
[1] A laminate including
   a first metal layer,
   an insulating layer disposed on the first metal layer, and
   a second metal layer disposed on the insulating layer,
   wherein:
   the insulating layer has a Tg of 25°C or more and 90°C or less; and
   a ratio (α2/α1) of a coefficient of linear expansion α2 in a rubbery region of the insulating layer with respect to a coefficient of linear expansion α1 in a glass region of the insulating layer is 4.3 or more and 8.0 or less.
[2] The laminate described in [1], wherein:
   the insulating layer contains an insulating resin cured body and an inorganic filler; and
   the insulating resin cured body is a cured body of a resin composition containing a thermosetting resin and a curing agent.
[3] The laminate described in [2], wherein: the thermosetting resin is an epoxy resin; and the curing agent is an amine-based curing agent.
[4] The laminate described in [2] or [3], wherein the content of the inorganic filler with respect to the total volume of the insulating layer is 40 vol.% or more and 80 vol.% or less.
[5] A circuit board including
   a metal layer,
   an insulating layer disposed on the metal layer, and
   a metal circuit part disposed on the insulating layer,
   wherein:
   the insulating layer has a Tg of 25°C or more and 90°C or less; and
   a ratio (α2/α1) of a coefficient of linear expansion α2 in a rubbery region of the insulating layer with respect to a coefficient of linear expansion α1 in a glass region of the insulating layer is 4.3 or more and 8.0 or less.
[6] The circuit board described in [5], wherein:
   the insulating layer contains an insulating resin cured body and an inorganic filler; and
   the insulating resin cured body is a cured body of a resin composition containing a thermosetting resin and a curing agent.
[7] The circuit board described in [6], wherein: the thermosetting resin is an epoxy resin; and the curing agent is an amine-based curing agent.
[8] The circuit board described in [6] or [7], wherein the content of the inorganic filler with respect to the total volume of the insulating layer is 40 vol.% or more and 80 vol.% or less.
[9] A method for producing a circuit board, the method including:
   a preparation step for preparing the laminate described in any one of [1] to [4]; and
   a circuit part formation step for removing a portion of the first metal layer or a portion of the second metal layer of the laminate and forming a metal circuit part.

### EFFECTS OF INVENTION

According to one aspect of the present disclosure, there is provided a laminate which is useful in the production of a circuit board having both excellent adhesive strength and excellent heat cycle properties. Further, according to one aspect of the present disclosure, there are provided: a circuit board having both excellent adhesive strength and excellent heat cycle properties; and a production method therefor.

### BRIEF DESCRIPTION OF DRAWINGS

FIG. 1 is a cross-sectional view showing one embodiment of a laminate.
FIG. 2 is a cross-sectional view showing one embodiment of a circuit board.

### DESCRIPTION OF EMBODIMENTS

A preferred embodiment of the present disclosure shall be explained in detail below.

### [Laminate]

A laminate of the present embodiment includes a first metal layer, an insulating layer disposed on the first metal layer, and a second metal layer disposed on the insulating layer. In the present embodiment, the insulating layer has a Tg of 25°C or more and 90°C or less. Further, a ratio (α2/α1) of a coefficient of linear expansion α2 in a rubbery region of the insulating layer with respect to a coefficient of linear expansion α1 in a glass region of the insulating layer is 4.3 or more and 8.0 or less.

According to the laminate of the present embodiment, by processing the first metal layer or the second metal layer to form a metal circuit part, it is possible to produce a circuit board having both excellent adhesive strength and excellent heat cycle properties.

Herein, the Tg of the insulating layer is measured by the method described below.

### <Measurement of insulating layer Tg (glass transition temperature)>

The Tg (glass transition temperature) of the insulating layer is measured by using a dynamic viscoelastic measurement device (DMA). Specifically, for a sample having a thickness of 100 µm and a width of 5 mm, in a curve obtained by a dynamic viscosity measurement under conditions of a temperature increase rate of 5°C/min. and a frequency of 1 Hz using a DMA device (RSA III, manufactured by TA Instruments), a temperature at which a loss tangent tanδ shows a maximum value is deemed to be the Tg (glass transition temperature) of the insulating layer.

Herein, the coefficient of linear expansion α1 in a glass region of the insulating layer and the coefficient of linear expansion α2 of a rubbery region of the insulating layer are measured using the method described below.

### <Measurement of coefficients of linear expansion α1 and α2 of insulating layer>

The coefficients of linear expansion are measured by using a thermomechanical analyzer (TMA). Specifically, using a thermomechanical analyzer (Q400, manufactured by TA Instruments), a two-cycle measurement is performed in a compression mode under temperature conditions of from -40°C to 200°C, with a temperature increase rate of 10°C/min. and a load of 0.1 N, and the value of an in-plane-direction coefficient of linear expansion is measured. Note that the value of the second cycle is employed as the coefficient of linear expansion.

The glass region of the insulating layer is a region in which the temperature is less than the Tg, and the coefficient of linear expansion α1 in the glass region may be the coefficient of linear expansion α1 at a temperature of, for example, (Tg-50°C) or more and (Tg-20°C) or less. The rubbery region of the insulating layer is a region in which the temperature exceeds the Tg, and the coefficient of linear expansion α2 in the rubbery region may be the coefficient of linear expansion α2 at a temperature of, for example, (Tg+20°C) or more and (Tg+50°C) or less.

In the present embodiment, the Tg of the insulating layer is 25°C or more. When the Tg of the insulating layer is less than 25°C, there are cases in which, due to softening at room temperature, it is not possible to obtain sufficient adhesive strength with the first metal layer and the second metal layer. From the viewpoint that superior adhesive strength is easily obtained, the Tg of the insulating layer may be 30°C or more or 35°C or more.

In the present embodiment, the Tg of the insulating layer is 90°C or less. When the Tg of the insulating layer is 90°C or less, the insulating layer softens in a high temperature region at which strain is likely to occur and it is possible to maintain high reliability through stress mitigation by the insulating layer. From the viewpoint that the foregoing effect is obtained to a more remarkable degree, the Tg of the insulating layer may be 80°C or less, 70°C or less, or 60°C or less.

The Tg of the insulating layer can be adjusted, as appropriate, via the constitution of the resin material (for example, the insulating resin cured body described later) that constitutes the insulating layer. For example, when the resin material has a skeleton (for example, a siloxane skeleton, alkylene glycol skeleton, ether group, etc.) in which molecular motion easily occurs, there is a tendency for the Tg to be low. Further, when the resin material has a skeleton (for example, a bisphenol skeleton, biphenyl skeleton, naphthyl skeleton, etc.) which is rigid and in which molecular motion does not easily occur, there is a tendency for the Tg to be high.

In the present embodiment, the ratio (α2/α1) of the coefficient of linear expansion α2 in a rubbery region of the insulating layer with respect to the coefficient of linear expansion α1 in a glass region of the insulating layer is 4.3 or more. In an insulating layer in which the ratio (α2/α1) is 4.3 or more, deformation occurs easily in the rubber region and a stress mitigation effect in a high temperature region is obtained to a remarkable degree.

In the present embodiment, the ratio (α2/α1) is 8.0 or less. When the ratio (α2/α1) exceeds 8.0, due to excessive deformation in the rubbery region, there are cases in which it is no longer possible to maintain a shape as a board. From the viewpoint that excessive deformation is suppressed and higher reliability is obtained, the ratio (α2/α1) may be 7.5 or less, 7.0 or less, or 6.5 or less.

The coefficient of linear expansion of the insulating layer can be adjusted, as appropriate, by changing the cross-link density or the molecular weight between cross-link points of the resin material (for example, the insulating resin cured body described layer) that constitutes the insulating layer. For example, when a highmolecular-weight resin is used as a resin before cross-linking, there is a tendency for the molecular weight between cross-link points to be large and for the coefficient of linear expansion to be large. Meanwhile, when a low-molecular-weight resin is used as a resin before cross-linking, there is a tendency for the molecular weight between cross-link points to be small and for the coefficient of linear expansion to be small. Further, by using a polyfunctional curing agent having a plurality of reaction points as a curing agent, there is a tendency for the cross-link density to improve and for the coefficient of linear expansion to be small.

Further, the coefficient of linear expansion of the insulating layer can also be adjusted by the inorganic filler. The coefficient of linear expansion of inorganic fillers generally tends to be small in comparison with the coefficient of linear expansion of resin materials (for example, the coefficient of linear expansion of alumina is approximately 7.2 ppm and the coefficient of linear expansion of boron nitride is approximately 0 ppm). Due thereto, by changing the type of inorganic filler and the filling amount thereof, as appropriate, it is possible to adjust the coefficient of linear expansion of the insulating layer.

The insulating layer may, for example, contain an insulating resin cured body and an inorganic filler.

The insulating resin cured body may, for example, be a cured body of a resin composition containing a thermosetting resin and a curing agent.

Examples of thermosetting resins include epoxy resins, silicone resins, phenol resins, cyanate resins, melamine resins, urea resins, thermosetting polyimide resins, and unsaturated polyester resins, etc. Thereamong, from the viewpoint of adhesiveness and electrical insulation properties, epoxy resins are preferred.

Examples of epoxy resins include Bisphenol A-type epoxy resins, Bisphenol S-type epoxy resins, Bisphenol F-type epoxy resins, hydrogenated Bisphenol A-type epoxy resins, polypropylene glycol-type epoxy resins, polytetramethylene glycol-type epoxy resins, naphthalene-type epoxy resins, phenylmethane-type epoxy resins, tetrakis phenolmethane-type epoxy resins, biphenyl-type epoxy resins, epoxy resins having a triazine ring, Bisphenol A alkylene oxide adduct-type epoxy resins, dicyclopentadiene-type epoxy resins, cresol novolac-type epoxy resins, and phenol novolac-type epoxy resins, etc. The epoxy resin may be used alone or as a combination of two or more.

The curing agent should be a curing agent which is capable of curing a thermosetting resin, and may be selected, as appropriate, from publicly-known curing agents according the type of thermosetting resin.

When the thermosetting resin is an epoxy resin, examples of the curing agent (curing agent for an epoxy resin) include amine-based curing agents, phenol-based curing agents, anhydride-based curing agents, and thiol-based curing agents, etc.

The amine-based curing agent should be a curing agent which has an amino group and is capable of curing an epoxy resin. Examples of the amine-based curing agent include aromatic amine-based curing agents, aliphatic amine-based curing agents, and dicyandiamide, etc.

Any amine-based curing agent which is publicly-known as a curing agent for epoxy resins can be used as the amine-based curing agent without any particular limitations. A commercially available product may be used as the amine-based curing agent. For example, an aliphatic polyamine, an alicyclic polyamine, an aromatic polyamine, etc., can be preferably used.

The phenol-based curing agent should be a curing agent that has a plurality of phenolic hydroxyl groups and is capable of curing an epoxy resin. Examples of the phenol-based curing agent include novolac-type phenol resins and resol-type phenol resins, etc.

Any phenol-based curing agent which is publicly-known as a curing agent for epoxy resins can be used as the phenol-based curing agent without any particular limitations. A commercially available product may be used as the phenol-based curing agent. For example, phenol novolac, xylylene novolac, Bisphenol A-type novolac, etc., can be preferably used.

The anhydride-based curing agent should be a curing agent that has a structure in which two carboxyl groups are dehydration-condensed and is capable of curing an epoxy resin. Examples of the anhydride-based curing agent include aliphatic acid anhydrides and aromatic acid anhydrides, etc.

Any anhydride-based resin curing agent which is publicly-known as a curing agent for epoxy resins can be used as the anhydride-based curing agent without any particular limitations. A commercially available product may be used as the anhydride-based curing agent. For example, a phthalic acid anhydride derivative, a maleic acid anhydride derivative, etc., can be preferably used.

The thiol-based curing agent should be a curing agent that has a plurality of mercapto groups and is capable of curing an epoxy resin. Examples of the thiol-based curing agent include aliphatic thiol-based curing agents and aromatic thiol-based curing agents, etc.

Any thiol-based curing agent which is publicly-known as a curing agent for epoxy resins can be used as the thiol-based curing agent without any particular limitations. A commercially available product may be used as the thiol-based curing agent. For example, an aliphatic polythioether, an aliphatic polythioester, an aromatic group-containing polythioether, etc., can be preferably used.

The curing agent for epoxy resins may include a first amine-based curing agent having an amine equivalent amount of 300 or less and a second amine-based curing agent having an amine equivalent amount of 800 or more. By combining and using two amine-based curing agents having different amine equivalent amounts, density differences occur in the cross-link structure of the cured body and it is easier to obtain an insulating layer in which the ratio (α2/α1) is large.

The first amine-based curing agent and the second amine-based curing agent are preferably aliphatic polyamines.

The content of the curing agent in the resin composition with respect to 100 parts by mass of the thermosetting resin may, for example, be 1 part by mass or more and may be 3 parts by mass or more, 5 parts by mass or more, 7 parts by mass or more, or 9 parts by mass or more. Further, the content of the curing agent in the resin composition with respect to 100 parts by mass of the thermosetting resin may, for example, be 30 parts by mass or less and may be 25 parts by mass or less, 20 parts by mass or less, or 15 parts by mass or less.

The resin composition may further contain a component other than those described above. Examples of the other component include a surface modifier such as a coupling agent, etc., a heavy metal deactivator, a leveling agent, a defoamant, a wetting agent, a stabilizer, a curing promoter, and an ion scavenger, etc.

The resin composition may be a coating liquid further containing a solvent. The solvent is not particularly limited and should be a solvent which is capable of being used as a coating liquid. The solvent may be used alone or as a combination of two or more.

Examples of the solvent include hydroxyl group-containing aliphatic hydrocarbons such as alcohols, etc., carbonyl group-containing hydrocarbons such as ketones, etc., aliphatic hydrocarbons, halogenated aliphatic hydrocarbons, halogenated aromatic hydrocarbons, ethers, aromatic hydrocarbons, nitrogen-containing compounds, and aprotic solvents, etc. Specific examples of the solvent include methanol, ethanol, propanol, isopropanol, acetone, methyl ethyl ketone, cyclohexanone, cyclopentanone, pentane, hexane, dichloromethane, chloroform, trichloroethane, chlorobenzene, dichlorobenzene, orthodichlorobenzene, butyl cellosolve, tetrahydrofuran, benzene, toluene, xylene, N-methylpyrrolidone (NMP), pyridine, acetonitrile, dimethylformamide (DMF), dimethylsulfoxide (DMSO), and dimethylformamide, etc.

The content of the solvent in the resin composition with respect to 100 parts by mass of the thermosetting resin may, for example, be 10 parts by mass or more and may be 20 parts by mass or more, 30 parts by mass or more, or 50 parts by mass or more. Further, the content of the solvent in the resin composition with respect to 100 parts by mass of the thermosetting resin may, for example, be 500 parts by mass or less and may be 300 parts by mass or less, 250 parts by mass or less, or 200 parts by mass or less.

The preferred numerical range for the Tg of the insulating resin cured body may be the same as the preferred numerical range for the Tg of the insulating layer.

The Tg (glass transition temperature) of the insulating resin cured body is measured by the method described below.

### <Measurement of glass transition temperature>

The Tg (glass transition temperature) of the insulating resin cured body is measured by using a dynamic viscoelastic measurement device (DMA). Specifically, for a sample having a thickness of 100 µm and a width of 5 mm, in a curve obtained by a dynamic viscosity measurement under conditions of a temperature increase rate of 5°C/min. and a frequency of 1 Hz using a DMA device (RSA III, manufactured by TA Instruments), a temperature at which a loss tangent tanδ shows a maximum value is deemed to be the Tg (glass transition temperature) of the insulating resin cured body.

The content of the insulating resin cured body in the insulating layer with respect to the total volume of the insulating layer may, for example, be 20 vol.% or more, is preferably 30 vol.% or more, and more preferably 40 vol.% or more. Further, the content of the insulating resin cured body in the insulating layer with respect to the total volume of the insulating layer may, for example, be 99 vol.% or less, is preferably 90 vol.% or less, and more preferably 80 vol.% or less.

Examples of inorganic fillers include inorganic fillers configured from aluminum oxide, silica, aluminum nitride, silicon nitride, and boron nitride, etc.

From the viewpoint of suppressing decreases in electrical insulation properties in high-temperature, high-humidity environments caused by hydrolysis of the inorganic material, the inorganic filler preferably has an inorganic material selected from the group consisting of aluminum oxide, silica, silicon nitride, and boron nitride as a main component. The content of the inorganic material in the inorganic filler with respect to the total mass of the inorganic filler is preferably 60 mass% or higher, more preferably 70 mass% or higher, and even more preferably 80 mass% or higher.

Note that when the inorganic filler includes a large amount of aluminum nitride, for example, there are cases in which hydrolysis of the aluminum nitride occurs in high-temperature, high-humidity environments and electrical insulation properties decrease. Due thereto, the content of aluminum nitride in the inorganic filler with respect to the total mass of the inorganic filler is preferably 40 mass% or less, more preferably 30 mass% or less, and even more preferably 20 mass% or less. As described above, by using an inorganic material selected from the group consisting of aluminum oxide, silica, silicon nitride, and boron nitride as a main component, such decreases in electrical insulation properties caused by hydrolysis are suppressed to a remarkable degree.

The form of the inorganic filler is not particularly limited and may be particulate, scaly, polygonal, etc., with particulate being preferred.

The maximum particle size of the inorganic filler may, for example, be 50 µm or less, is preferably 20 µm or less, and more preferably 15 µm or less. By having such a maximum particle size, the electrical insulation properties of the insulating layer tend to improve further. Further, the minimum particle size of the inorganic filler is not particularly limited, but from the viewpoint that the thermal conductivity of the insulating layer further improves, may, for example, be 0.05 µm or more and is preferably 0.1 µm or more. Note that herein, the maximum particle size and the minimum particle size of the inorganic filler indicate, respectively, a d90 diameter and a d10 diameter in a volume-based particle distribution, and said diameters are measured with a laser diffraction particle size distribution measuring device.

The content of the inorganic filler in the insulating layer with respect to the total volume of the insulating layer may, for example, be 50 vol.% or more, is preferably 60 vol.% or more, and more preferably 70 vol.% or more. Further, the content of the inorganic filler in the insulating layer with respect to the total volume of the insulating layer may, for example, be 80 vol.% or less, is preferably 78 vol.% or less, and more preferably 75 vol.% or less.

The insulating layer can, for example, be formed by curing a coating film of a coating liquid containing the resin composition and the inorganic filler described above.

Curing the coating film can, for example, be performed by means of a heat treatment. The heat treatment may be performed in one stage or may be performed in two stages. By performing the heat treatment in two stages, the insulating layer can be formed via a semicured body of the coating film. The temperature and time for the heat treatment can be changed, as appropriate, in accordance with the types of thermosetting resin and curing agent, etc.

When the heat treatment is performed in one stage, the temperature of the heat treatment may, for example, be 40-250°C and is preferably 70-180°C. The time for the heat treatment may, for example, be 0.5-48 hours and is preferably 1-6 hours.

When the heat treatment is performed in two stages, the temperature of the heat treatment in the first stage (first heat treatment) may, for example, be 40-150°C and is preferably 50-100°C. The time for the first heat treatment may, for example, be 0.2-8 hours and is preferably 0.5-5 hours. Further, the temperature of the heat treatment in the second stage (second heat treatment) may, for example, be 70-250°C and is preferably 120-180°C. The time for the heat treatment may, for example, be 0.5-9 hours and is preferably 1-6 hours.

The insulating layer may, for example, be formed by disposing a coating film of the composition described above or a semicured body of the coating film between a first metal layer and a second metal layer and heating and pressurizing. The pressurizing conditions are not particularly limited. The pressurizing may, for example, be performed with a surface pressure of 1 MPa or more, preferably 5 MPa or more, and more preferably 8 MPa or more. Further, the pressurizing may, for example, be performed with a surface pressure of 30 MPa or less, preferably 25 MPa or less, and more preferably 20 MPa or less.

The thickness of the insulating layer is not particularly limited, but from the viewpoint of electrical insulation properties, may, for example, be 30 µm or more, is preferably 50 µm or more, and more preferably 80 µm or more. Further, from the viewpoint of heat resistance, the thickness of the insulating layer may, for example, be 500 µm or less, is preferably 300 µm or less, and more preferably 200 µm or less.

The metal material constituting the first metal layer is not particularly limited and may, for example, be aluminum, copper, iron, silver, gold, zinc, nickel, or tin, and may be an alloy including the foregoing metals, etc. The first metal layer may be configured from one metal material or may be configured from two or more metal materials.

The first metal layer preferably contains at least one metal atom (M1) selected from the group consisting of aluminum, copper, iron, silver, gold, zinc, nickel, and tin. The metal atom (M1) is preferably at least one metal atom selected from the group consisting of aluminum, copper, and iron, and more preferably is at least one metal atom selected from the group consisting of aluminum and copper.

The content of the metal atom (M1) with respect to the total mass of the first metal layer may, for example, be 50 mass% or more, is preferably 60 mass% or more, more preferably 70 mass% or more, and even more preferably 80 mass% or more, may be 90 mass% or more, and may be 100 mass%.

The first metal layer may, for example, be a metal plate. The thickness of the first metal layer is not particularly limited, but may, for example, be 0.01 mm or more, is preferably 0.1 mm or more, and more preferably 1.0 mm or more. Further, the thickness of the first metal layer may, for example, be 10 mm or less, and is preferably 5.0 mm or less, and more preferably 3.0 mm or less.

A bonding surface (S1) of the first metal layer with the insulating layer may be a surface that has undergone a roughening process. The method for performing the roughening process is not particularly limited and any publicly-known roughening process can be used without any particular limitations. Examples of the roughening process include a chemical etching process, a blasting process, and a buffing process, etc.

The metal material constituting the second metal layer is not particularly limited and may, for example, be aluminum, copper, iron, silver, gold, zinc, nickel, or tin, and may be an alloy including the foregoing metals, etc. The second metal layer may be configured from one metal material or may be configured from two or more metal materials.

The second metal layer preferably contains at least one metal atom (M2) selected from the group consisting of aluminum, copper, iron, silver, gold, zinc, nickel, and tin. The metal atom (M2) is preferably at least one metal atom selected from the group consisting of aluminum, copper, and iron, and more preferably is at least one metal atom selected from the group consisting of aluminum and copper.

The content of the metal atom (M2) with respect to the total mass of the second metal layer may, for example, be 50 mass% or more, is preferably 60 mass% or more, more preferably 70 mass% or more, and even more preferably 80 mass% or more, may be 90 mass% or more, and may be 100 mass%.

The second metal layer may, for example, be a metal foil. The thickness of the second metal layer is not particularly limited, but may, for example, be 0.01 mm or more, is preferably 0.02 mm or more, and more preferably 0.03 mm or more. Further, the thickness of the second metal layer may, for example, be 5.0 mm or less, is preferably 3.0 mm or less, and more preferably 1.0 mm or less.

A bonding surface (S2) of the second metal layer with the insulating layer may be a surface that has undergone a roughening process. The method for performing the roughening process is not particularly limited and any publicly-known roughening process can be used without any particular limitations. Examples of the roughening process include a chemical etching process, a blasting process, and a buffing process, etc.

The method for producing the laminate is not particularly limited. For example, the laminate can be produced by a method including: a step of coating, on a first metal layer, a coating liquid including a resin composition and an inorganic filler, and curing or semicuring; and a step of bonding a second metal layer on the cured or semicured composition (that is, on an insulating resin cured body or semicured body). The method may also further include a step of curing the semicured body. The bonding of the second metal layer may, for example, be performed by a roller lamination method or by a laminating press method, etc.

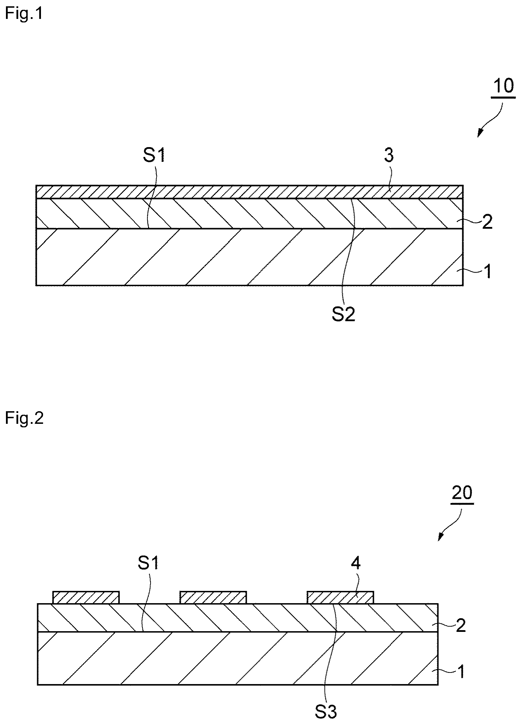

FIG. 1 is a cross-sectional view showing a preferred embodiment of the laminate. A laminate 10 shown in FIG. 1 includes: a first metal layer 1; an insulating layer 2 disposed on the first metal layer 1; and a second metal layer 3 disposed on the insulating layer 2. The first metal layer 1 has a bonding surface S1 with the insulating layer 2. The second metal layer 3 has a bonding surface S2 with the insulating layer 2.

By processing the second metal layer 3 of the laminate 10 to a prescribed shape to form a metal circuit part, a circuit board can be produced easily.

The method for forming the metal circuit part is not particularly limited and a publicly-known processing method should be applied.

### [Circuit board]

A circuit board of the present embodiment includes: a metal layer; an insulating layer disposed on the metal layer; and a metal circuit part disposed on the insulating layer.

In the present embodiment, the Tg of the insulating layer is 25°C or more and 90°C or less, and a ratio (α2/α1) of a coefficient of linear expansion α2 in a rubbery region of the insulating layer with respect to a coefficient of linear expansion α1 in a glass region of the insulating layer is 4.3 or more and 8.0 or less.

The circuit board of the present embodiment may be produced by removing a portion of the second metal layer of the laminate described above. That is, the insulating layer in the circuit board of the present embodiment may be the same as the insulating layer in the laminate described above, and the metal layer in the circuit board of the present embodiment may be the same as the first metal layer in the laminated described above.

The metal circuit part in the circuit board of the present embodiment may be a remaining section after a portion of the second metal layer of the laminate described above is removed. That is, the material constituting the metal circuit part and the thickness of the metal circuit part may be the same as the material constituting the second metal layer and the thickness thereof.

FIG. 2 is a cross-sectional view showing a preferred embodiment of the circuit board. A circuit board 20 shown in FIG. 2 is a circuit board produced from the laminate shown in FIG. 1 and includes: the first metal layer 1; the insulating layer 2 disposed on the first metal layer 1; and a metal circuit part 4 disposed on the insulating layer 2. The first metal layer 1 has a bonding surface S1 with the insulating layer 2. The metal circuit part 4 has a bonding surface S3 with the insulating layer 2.

Preferred embodiments of the present invention were described above, but the present invention is not limited to the above embodiments.

### EXAMPLES

Hereinafter, the present invention is explained in further detail using examples, but the present invention is not limited to the examples below.

The raw materials used in the examples and comparative examples are indicated below.

### <Epoxy resin>

- Epoxy resin 1 (Bisphenol A/F-type epoxy resin, "YD-6020" manufactured by Nippon Steel Chemical & Material Co., Ltd.)
- Epoxy resin 2 (specialty epoxy resin "YX-7110" manufactured by Mitsubishi Chemical Group Corporation)
- Epoxy resin 3 (hydrogenated Bisphenol A-type epoxy resin, "YX-8000" manufactured by Mitsubishi Chemical Group Corporation)
- Epoxy resin 4 (Bisphenol F-type epoxy resin, "YDF-170" manufactured by Nippon Steel Chemical & Material Co., Ltd.)
- Epoxy resin 5 (dicyclopentadiene-type epoxy resin, "HP-7200" manufactured by DIC Corporation)
- Epoxy resin 6 (Bisphenol A-type epoxy resin, "EXA-850CRP" manufactured by DIC Corporation)

### <Amine-based curing agent>

- Amine-based curing agent 1 (aliphatic amine, amine equivalent amount 200, "D-400" manufactured by Huntsman)
- Amine-based curing agent 2 (aliphatic amine, amine equivalent amount 1040, "D-2000" manufactured by Huntsman)
- Amine-based curing agent 3 (aromatic amine, "H84B" manufactured by Nihon Gosei Kako Co., Ltd)

### <Curing promoter>

- Curing promoter 1 (2-phenyl-4,5-dihydroxymethylimidazol, "2PHZ-PW" manufactured by Shikoku Kasei Co., Ltd.)

### <Inorganic filler>

- Inorganic filler 1 (spherical alumina, average particle size 10 µm, "DAS10" manufactured by Denka Co., Ltd.)
- Inorganic filler 2 (spherical alumina, average particle size 2 µm, "AA2" manufactured by Denka Co., Ltd.)
- Inorganic filler 3 (spherical alumina, average particle size 0.5 µm, "AA05" manufactured by Sumitomo Chemical Co., Ltd.)

### <Solvent>

- Solvent 1 (ethyl cellosolve)
- Solvent 2 (IP clean LX)

### (Example 1)

### (i) Preparation of coating liquid for forming insulating layer

The raw materials were mixed at the blend ratios (parts by mass) shown in Table 1 below to obtain a coating liquid for forming an insulating layer.

Specifically, the epoxy resin was stirred and dissolved in the solvent at 95°C. Next, after cooling to room temperature, the remaining raw materials (amine-based curing agent, curing promoter, and inorganic filler) were added and stir-mixed for 15 minutes using a planetary mixer to obtain a coating liquid for forming the insulating layer.

### (ii) Fabrication of laminate

The coating liquid obtained in (i) above was applied on a copper foil (second metal layer) with a clearance of 190-200 µm using a comma coater and then heated at 80°C for 30 minutes to obtain a composite body of a semicured body layer and a copper foil. Next, the composite body was placed on an aluminum plate (4045 material) (thickness: 2.0 mm) (first metal layer) that had undergone a degreasing treatment so that the semicured body layer was in contact with the aluminum plate, and using a vacuum press, was pressed at 5 MPa and 200°C for 2.5 hours to obtain a laminate.

### (Examples 2 and 3 and Comparative Examples 1-3)

Other than changing the raw materials used and blend ratios thereof to those shown in Table 1, the coating liquid for forming the insulating layer and the laminate were obtained in the same manner as in Example 1.

**TABLE 1**

| BLEND RATIO (PARTS BY MASS) | EX 1 | EX 2 | EX 3 | COMP EX 1 | COMP EX 2 | COMP EX 3 |
|---|---|---|---|---|---|---|
| FILLER FILLING AMOUNT | 68 VOL% | 60 VOL% | 53 VOL% | 66 VOL% | 51 VOL% | 70 VOL% |
| EPOXY RESIN 1 (YD-6020) | 4.78 | - | 3.09 | - | - | - |
| EPOXY RESIN 2 (YX-7110) | 4.78 | - | - | - | - | - |
| EPOXY RESIN 3 (YX-8000) | - | - | 9.29 | - | - | - |
| EPOXY RESIN 4 (YDF-170) | - | 3.09 | - | - | - | - |
| EPOXY RESIN 5 (HP-7200) | - | 7.21 | - | - | - | - |
| EPOXY RESIN 6 (EXA-850CRP) | - | - | - | 9.12 | 15.17 | |
| SILICONE RESIN (TSE-3221 S) | - | - | - | - | - | 10.68 |
| AMINE-BASED CURING AGENT 1 (D-400) | 0.15 | 2.16 | 3.29 | - | - | - |
| AMINE-BASED CURING AGENT 2 (D-2000) | 1.16 | 1.44 | 2.2 | - | - | - |
| AMINE-BASED CURING AGENT 3 (H84B) | - | 0.39 | - | 3.11 | 5.16 | - |
| CURING PROMOTER 1 (2PHZ-PW) | 0.01 | - | - | - | - | - |
| INORGANIC FILLER 1 (DAS10) | 58.52 | 55.9 | 53.73 | 57.49 | 51.26 | 62.4 |
| INORGANIC FILLER 2 (AA2) | 12.29 | 11.74 | 4.61 | 5.17 | 4.61 | 12.48 |
| INORGANIC FILLER 3 (AA05) | 5.27 | 5.03 | 10.75 | 12.07 | 10.76 | 5.35 |
| SOLVENT 1 (ETHYL CELLOSOLVE) | 13.04 | 13.04 | 13.04 | 13.04 | 13.04 | - |
| SOLVENT 2 (IP CLEAN LX) | - | - | - | - | - | 909 |

### <Coefficient of linear expansion of insulating layer>

The coating liquids for forming the insulating layer which were prepared in the examples and comparative examples were used to evaluate the coefficient of linear expansion of the insulating layer by the method described below.

First, a hand coater was used to apply, with a clearance of 0.46 mm, the coating liquid for forming the insulating layer on a PET film that had undergone a peeling process. After being coated, the sheet was placed on an aluminum plate and heated in an oven at 90°C for 30 minutes to obtain a semicured body with a thickness of approximately 0.25 mm.

Next, a plurality of the semicured bodies were laminated and pressed using a vacuum press (5 MPa, 200°C, 2.5 hours) to obtain a cured body. Note that the number of laminated layers of the semicured body was set at five.

A grinding machine was used to process the obtained cured body so as to be 5 mm × 5 mm × 5 mm and, using a thermomechanical analyzer (Q400, manufactured by TA Instruments), a two-cycle measurement was performed in a compression mode under temperature conditions of from -40°C to 200°C, with a temperature increase rate of 10°C/min. and a load of 0.1 N, and the value of an in-plane-direction coefficient of linear expansion was measured. Note that the value of the second cycle was employed as the coefficient of linear expansion. A coefficient of linear expansion in a temperature range from (Tg-50°C) to (Tg-20°C) was determined as the coefficient of linear expansion α1 in the glass region, and a coefficient of linear expansion in a temperature range from (Tg+20°C) to (Tg+50°C) was determined as the coefficient of linear expansion α2 in the rubbery region. The results are shown in Table 2.

### <Tg of insulating layer>

The Tg (glass transition temperature) of the insulating layer was evaluated by the following method. The results are shown in Table 2.

The Tg (glass transition temperature) of the insulating layer was measured by using a dynamic viscoelastic measurement device (DMA). Specifically, for a sample having a thickness of 100 µm and a width of 5 mm, in a curve obtained by a dynamic viscosity measurement under conditions of a temperature increase rate of 5°C/min. and a frequency of 1 Hz using a DMA device (RSA III, manufactured by TA Instruments), a temperature at which a loss tangent tanδ shows a maximum value was deemed to be the Tg (glass transition temperature) of the insulating layer.

### <Heat cycle test>

A heat cycle test was performed by the method described below using the laminates fabricated in the examples and comparative examples. The results are shown in Table 2.

A circuit pattern was formed by etching the laminate to obtain a circuit board. An R1608 (1.6×0.8 mm) chip resistor was mounted on the circuit pattern with a tin-silver-copper-based lead-free solder (manufactured by Senju Metal Industry Co., Ltd.). 3000 cycles of a -40°C to +125°C (each 20 minutes) air tank heat shock test were performed using the obtained electronic component-mounted board. Cross-sections of soldered connecting sections after the heat shock test were observed using a microscope, crack occurrence states were investigated, and assessed as described below.
A: crack length is less than 50% of total length of soldered connecting section
B: crack length is 50% or more of total length of soldered connecting section

<Measurement of peel strength>

Circuit board samples were fabricated and peel strength was measured by the method described below using the laminates fabricated in the examples and comparative examples. The results are shown in Table 2.

An etching resist was used to make a rectangular mask having a width of 10 mm and a length of 100 mm on prescribed location of a surface of the copper foil of the laminate. Next, the copper foil was etched with a copper (II) chloride aqueous solution and a rectangular copper circuit having a width of 10 mm and a length of 100 mm was formed on the surface of the starting plate copper foil. Then, the etching resist was removed to obtain a metal-based circuit board for evaluating peel strength. Peel strength was measured in compliance with JIS C 6481-1996. A "Tensilon RTG1210" (manufactured by A&D Co., Ltd.) was used as the measurement device.

**TABLE 2**

| | EX 1 | EX 2 | EX 3 | COMP EX 1 | COMP EX 2 | COMP EX 3 |
|---|---|---|---|---|---|---|
| Tg OF INSULATING LAYER | 41 | 52 | 39 | 125 | 104 | 11 |
| COEFFICIENT OF LINEAR EXPANSION α1 OF INSULATING LAYER | 16 | 18 | 24 | 16 | 25 | 18 |
| COEFFICIENT OF LINEAR EXPANSION α2 OF INSULATING LAYER | 96 | 79 | 111 | 67 | 96 | 25 |
| α2/α1 CYCLE TEST | A | 4.39 | 4.63 | 4.19 | 3.84 | 1.39 |
| PEEL STRENGTH (N/cm) | 22 | 20.6 | 17.6 | 27.3 | 22.1 | 10.5 |

### <Measurement of strain amount>

Strain amounts due to temperature change were measured by the method described below using the laminates fabricated in the examples and comparative examples.

The laminate was cut so as to have sides of 3.2 cm using a shearing machine, and then the sides were formed to 3.0 cm using a rotary grinder to obtain a test sample.

The strain amount was measured under the conditions described below using the obtained test sample.

### Measurement method: Strain gauge method

Constant temperature chamber: constant temperature chamber T3119, manufactured by Instron.

Strain gauge: KFGT-5-120-C1-11 (gauge length: 5 mm), manufactured by Kyowa Dengyo Co., Ltd.

Two strain gauges were adhered at positions opposing the copper foil side and the substrate side of the test sample. Further, another strain gauge was adhered on the copper foil side in a direction orthogonal to the adhered strain gauge. The test sample with the strain gauges adhered thereto was left to stand inside the constant temperature chamber.

After acquiring an initial value (strain=0) of the strain gauge, the test sample was cooled to -40°C, then the temperature was increased to 125°C, and thereafter was cooled to room temperature. Strain (%) was measured at -40°C, -10°C, 20°C, 40°C, 50°C, 60°C, 80°C, 100°C, and 125°C.

From the obtained results, the amount of increase in strain (×10⁻⁶/°C) from -40°C to 20°C, and the amount of increase in strain (×10⁻⁶/°C) from 60°C to 125°C were determined. The results are shown in Table 3.

**TABLE 3**

| | EX 1 | EX 2 | EX 3 | COMP EX 1 | COMP EX 2 | COMP EX 3 |
|---|---|---|---|---|---|---|
| AMOUNT OF INCREASE IN STRAIN (-40°C TO 20°C) | 19.07 | 21.04 | 18.61 | 21.27 | 20.57 | 16.02 |
| AMOUNT OF INCREASE IN STRAIN (60°C TO 125°C) | 18.63 | 19.68 | 17.04 | 23.02 | 23.6 | 15.82 |

As shown in Table 3, in the laminates of the examples, the amount of increase in strain on both the low temperature side and the high temperature side was smaller than in the laminates of the comparative examples, and thus, it was confirmed that strain due to temperature change is suppressed. Further, in the laminates of the examples, the amount of increase in strain on the high temperature side is smaller than the amount of increase in strain on the low temperature side, and thus, it was confirmed that, in high temperature environments in which decreases in reliability due to strain generally occur easily, strain is suppressed to a remarkable degree.

### REFERENCE SIGNS LIST

- 1: First metal layer
- 2: Insulating layer
- 3: Second metal layer
- 4: Metal circuit part
- 10: Laminate
- 20: Circuit board

## Claims

1. A laminate comprising
a first metal layer,
an insulating layer disposed on the first metal layer, and
a second metal layer disposed on the insulating layer,
wherein:
the insulating layer has a Tg of 25°C or more and 90°C or less; and
a ratio (α2/α1) of a coefficient of linear expansion α2 in a rubbery region of the insulating layer with respect to a coefficient of linear expansion α1 in a glass region of the insulating layer is 4.3 or more and 8.0 or less.

2. The laminate according to claim 1, wherein:
the insulating layer contains an insulating resin cured body and an inorganic filler; and
the insulating resin cured body is a cured body of a resin composition containing a thermosetting resin and a curing agent.

3. The laminate according to claim 2, wherein: the thermosetting resin is an epoxy resin; and the curing agent is an amine-based curing agent.

4. The laminate according to claim 2, wherein the content of the inorganic filler with respect to the total volume of the insulating layer is 40 vol.% or more and 80 vol.% or less.

5. A circuit board comprising
a metal layer,
an insulating layer disposed on the metal layer, and
a metal circuit part disposed on the insulating layer,
wherein:
the insulating layer has a Tg of 25°C or more and 90°C or less; and
a ratio (α2/α1) of a coefficient of linear expansion α2 in a rubbery region of the insulating layer with respect to a coefficient of linear expansion α1 in a glass region of the insulating layer is 4.3 or more and 8.0 or less.

6. The circuit board according to claim 5, wherein:
the insulating layer contains an insulating resin cured body and an inorganic filler; and
the insulating resin cured body is a cured body of a resin composition containing a thermosetting resin and a curing agent.

7. The circuit board according to claim 6, wherein: the thermosetting resin is an epoxy resin; and the curing agent is an amine-based curing agent.

8. The circuit board according to claim 6, wherein the content of the inorganic filler with respect to the total volume of the insulating layer is 40 vol.% or more and 80 vol.% or less.

9. A method for producing a circuit board, the method comprising:
a preparation step for preparing the laminate according to any one of claims 1 to 4; and
a circuit part formation step for removing a portion of the first metal layer or a portion of the second metal layer of the laminate and forming a metal circuit part.
